# EUROPEAN PATENT SPECIFICATION

(11) **EP 3 783 545 B1**
(45) Date of publication and mention of the grant of the patent: **24.09.2025**
(21) Application number: 19192356.4
(22) Date of filing: 19.08.2019
(51) Int. Cl.: G06Q 10/00, G06Q 10/06, G06Q 10/10, G06Q 50/04, G06Q 50/20

(54) **SYSTEM AND METHOD FOR AUTOMATICALLY CAPTURING TECHNOLOGY TRANSFER KNOWLEDGE**
SYSTEM UND VERFAHREN ZUR AUTOMATISCHEN ERFASSUNG VON TECHNOLOGIETRANSFERKENNTNISSEN
SYSTEME ET PROCEDE DE CAPTURE AUTOMATIQUE DE CONNAISSANCES DE TRANSFERT DE TECHNOLOGIE

(43) Date of publication of application: 24.02.2021
(73) Proprietor: Siemens Aktiengesellschaft, 80333 München (DE)
(72) Inventor: LASSALLE, Arnaud, 31650 Saint Orens de Gameville (FR)
(74) Representative: Siemens Patent Attorneys

(56) References cited:
- WO-A1-02/23287
- WO-A1-2018/205224
- WO-A1-2019/134091

## Description

The present invention relates to the transfer of technology from a first site wherein a product is developed to another site wherein the product that has been developed is going to be manufactured.

Pharmaceutical R&D aims to develop new products or molecules that can be then used at an industrial level. Typically, at some point of its development, a new product will be authorized to access the market, which requires an industrialization of its manufacturing. This overall process is known as New Product Introduction (NPI). It implies that product and process specifications that have been developed within a laboratory will be transferred from the R&D lab into the production factory. Such a transfer is called a technology transfer (or more commonly a "tech transfer"). Actually, R&D and Production teams use to work in silos, and collaboration between them is limited: they tend to interact only during the tech transfer.

A tech transfer is a process (or even a project) which consists in:
- physically transferring, from an issuing site (i.e. R&D lab) into a receiving site (i.e. industrial site) a new product, its manufacturing process, and a related analytical method (i.e. a precise method by which a process/product parameter or quality attribute is measured, typically in a Quality Control laboratory);
- potentially scaling-up batch sizes while doing the transfer;
- ensuring that the receiving site correctly masters the manufacturing process within its environment.

A problematic may result from the fact that the issuing site is usually concerned with requirements of developing new products as fast as possible (time driven development), while the receiving site is usually concerned with production requirements closely linked to costs (cost driven production) which gives rise to two different approaches about the required information regarding a tech transfer.

There are actually two kinds of knowledge that need to be shared between people of the issuing site and of the receiving site:
- explicit knowledge, which is formal and explicit, and can be easily communicated (i.e. product specifications);
- tacit knowledge, which is highly personal, hard to formalize and therefore, difficult to communicate to others. It has an important cognitive dimension.

All along a tech transfer project, the issuing site has to provide the receiving site with a documentation explaining how to develop the concerned new product. This is a very burdensome task: for instance, a process step comprising 3 days of manipulation in a lab typically represents a documentation writing effort of 3 months, including meetings and discussions. On top of that, it happens also that the resulting documentation may lack some relevant information for the receiving site.

For instance, it is particularly problematic to capture tacit knowledge from R&D experts which might be required for the industrial production of a new product. This might impact then the transfer project duration time, and consequently, the time to market, and the costs related to a specific project.

Known in the art solutions for capturing information exist, like the solutions described in WO 2019/134091 A1, WO 2018/205224 A1, or WO 02/23287 A1. However, they are not efficient enough for capturing the knowledge previously described. For instance, WO 2019/134091 A1 and WO 2018/205224 A1 propose an apparatus and a method capable of determining an emotional/psychological state of a user by using a chatbot and/or images. However, it can typically not capture a missing knowledge during a manipulation in a lab. The same applies to WO 02/23287 A1 which discloses a use of a video recording for presenting video information in connection with a machine setup. Such a system unfortunately fails also to efficiently capture a missing knowledge.

An objective of the present invention is to propose a system and a method for improving the transfer of technology between an issuing site and a receiving site, said system and method being able to efficiently capture tacit knowledge and transform it into explicit knowledge, so that information about a new product or process can be easily transferred to a receiving site, sparing the need of creating huge documentation for a new process or product, as well as time and costs for producing a new product.

This objective is achieved according to the present invention by a method and system for automatically capturing technology transfer knowledge according to the object of the independent claims. Dependent claims present further advantages of the invention.

The present invention concerns a method for automatically capturing technology transfer knowledge for the production of a new product, the method comprising:
- acquiring a production process model, wherein said production process model is a predefined structured model enabling to list successive process steps required for producing the new product, wherein for each step, the predefined structured model comprises one or several predefined fields that are each configured for enabling a recording of specific information (i.e. relevant technology transfer knowledge with respect to the concerned step) with respect to the production process of the new product;
- automatically capturing missing information within the production process model, wherein a processing unit is configured for determining whether one or several of said predefined fields are free of the specific information, and for each of said predefined fields which is free of said specific information, then the processing unit is configured for
   i) automatically triggering and conducting a chatbot for collecting audio and/or textual information from a person involved in a development of the new product, and storing the collected audio and/or textual information as specific information for the concerned field; and/or
   ii) automatically launching a video recording process for each field which is identified as requiring an equipment/machine handling for a process step of the production process,

   wherein said video recording process comprises automatically detecting an interaction with said equipment/machine, starting a video recording of the handling of the equipment/machine, automatically stopping the recording, notably as soon as the processing unit determines that said interaction with the equipment/machine stopped for a predetermined time threshold, and storing the video recording as specific information for the concerned field;
   until all fields of the predefined structured model have been reviewed by the processing unit;
- outputting a completed production process model once all fields have been reviewed by the processing unit.

The present invention proposes also a system for automatically capturing technology transfer knowledge for the production of a new product, the system comprising:
- an information acquisition system, connected to the processing unit and comprising at least an input device, e.g. a camera system and/or a keyboard device and/or a mouse device and/or a touchscreen device, for collecting information concerning production steps, said information acquisition system being further configured for acquiring a production process model that is a predefined structured model enabling to list successive process steps required for producing the new product, wherein for each step, the predefined structured model comprises one or several predefined fields that are each configured for enabling a recording of specific information with respect to the production process of the new product;
- a memory, connected to the information acquisition system, for storing the production process model and said specific information;
- the processing unit, comprising one or several processors, said processing unit being connected to the memory and the information acquisition system, said processing unit being configured for automatically capturing, by controlling the information acquisition system, missing information within the production process model by determining whether one or several of said predefined fields are free of said specific information, and for each of said predefined fields which is free of said specific information, then the processing unit is configured for
   i) automatically triggering and conducting, by means of the information acquisition system, a chatbot for collecting audio and/or textual information from a person involved in a development of the new product, and storing the collected audio and/or textual information as specific information for the concerned field; and/or
   ii) automatically launching, by means of the information acquisition system, a video recording process for each field which is identified as requiring an equipment/machine handling for a process step of the production process, wherein said video recording process comprises automatically detecting an interaction with said equipment/machine, starting a video recording of the handling of the equipment/machine, automatically stopping the recording, notably as soon as the processing unit determines that said interaction with the equipment/machine stopped for a predetermined time threshold, and storing the video recording in the memory as specific information for the concerned field;

until all fields of the predefined structured model have been reviewed by the processing unit;
the processing unit being further configured for storing a completed production process model in the memory once all fields have been reviewed by the processing unit.

Advantageously, the present invention proposes a method and a system capable of automatically capturing, within an issuing site, information required for the production of a new product by following a production process model that serves as a guide for determining which information is required/missing and triggering specific actions for collecting the required/missing information.

Preferred but not exclusive embodiments of the invention will now be described with reference to the accompanying drawing, which depicts in:
- Figure 1: schematically a flowchart representing a method according to the invention;
- Figure 2: an example of a production process model for a new pharmaceutical process according to the invention;
- Figure 3: schematically a preferred embodiment of a system according to the invention.

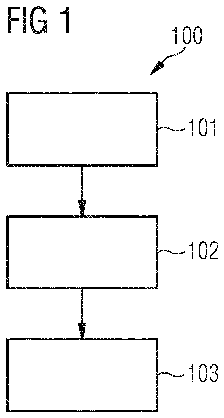

Figure 1 schematically provides an example of a method for automatically capturing technology transfer knowledge for the production of a new product. Said method enables to automatically acquire knowledge with respect to the production of a new product, the acquired knowledge being then easily transferable to a receiving site wherein an industrial manufacturing of the new product will take place.

At step 101, the system according to the invention acquires a production process model. The production process model is based on a predefined structured model that enables to list successive process steps that are required for producing the new product. Preferentially, a database or memory of the system according to the invention may comprise several predefined structured models which have been developed each for a specific kind of production process, e.g. for the production of drug, of physical material, etc., wherein the predefined structured model might be classified according to technologies in said database. The predefined structured model is configured for structuring the product/process knowledge to be passed during a tech transfer, thanks to a knowledge model organized into assets. The system according to the invention is indeed capable of determining whether a knowledge asset is failing or not within the production process model.

Typically, the predefined structured model comprises, for each step of the production process that is defined by the predefined structure model, one or several predefined fields that are each configured for enabling a recording of specific information or knowledge with respect to the production process of the new product. An operator of an issuing site may therefore choose/select in the database or memory one of the predefined structured models in function of the type of process or product to be developed, and that will have to be transferred to a receiving site. Optionally, the operator may fill one or some of the fields comprised within the selected predefined structured model. As soon as a predefined structured model has been selected by the operator, the system according to the invention is configured for acquiring said predefined structured model, i.e. it will upload it, e.g. into its memory, as a production process model that needs to be completed. The production process model acquired by the system according to the invention is thus one of the predefined structured model stored in a database, that has been selected by an operator, and that needs to be automatically completed by additional knowledge in order to describe the production process of a new product.

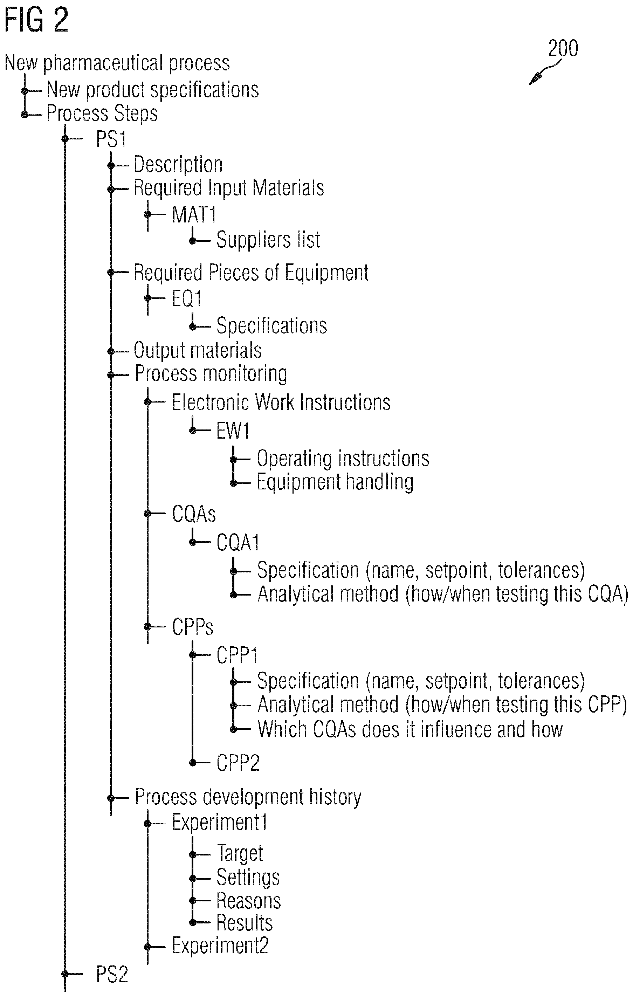

Figure 2 shows a preferred example of a production process model 200, which is configured for structuring in a list of different process steps the knowledge related to a production process, e.g. a new pharmaceutical process, for a product.

For each process step, one or several fields are defined. Said fields are for instance at least one or preferentially all of the following:
- a description field, wherein the step has to be textually described and/or illustrated, e.g. by some pictures, and wherein a name or reference or identifier of the process step might be recorded;
- a Bill Of Material field, i.e. a list of input materials required to perform the step. For each input material, a list of suppliers can be also recorded;
- a field for listing a set of machines or equipment which might be involved within the production process with respect to the considered step. For each equipment/machine, some information might be recorded like the category of equipment/machine, its function, its specifications, etc.;
- optionally, a material field for providing a description of materials produced by the step;
- an instruction field configured for specifying how the step has to be conducted, said instruction field being configured for comprising one or all of the following features:
   a) Electronic work instructions, including notably work instructions to be presented to an operator in charge of executing the step, as well as optionally know-how information configured for specifying equipment/machine handling with respect to the step;
   b) a list of Critical Quality Attributes (CQAs) that are required for certifying a quality of the product with respect to the considered step, said list being configured for enabling a specification of at least one value (e.g. setpoint, limit) for each CQAs and optionally a description of an analytical method to be performed in order to check each CQA;
   c) a list of Critical Control Parameters (CPPs) to be monitored during the step, said list being configured for enabling a specification of at least one value for each CPP (e.g. setpoint, limit) and optionally a description of an analytical method to be performed in order to check each CPP and an explanation of how each CPP influences one or several CQAs;
- a history field configured for collecting information with respect to an history of experiments conducted during the development of the considered step. Preferentially, the history field is configured for recording within the production process model and for each step, its target, settings that have been made (e.g. on the pieces of equipment/machines), a special target of the experiment, measured results, etc.

As previously explained, the present invention proposes to create/generate such predefined structured models for different fields of technologies/products/production processes, wherein a selection of one of said predefined structured models triggers its acquisition/uploading by the system according to the invention, and then its completion through the automatic capture of missing information. The invention proposes to digitally record a completed production process model for each new product process. For this purpose and preferentially, the information acquisition system according to the invention may also comprise a collaborative graphical user interface for acquiring a knowledge from an operator of an issuing site.

At step 102, the system is configured for automatically capturing missing information within the production process model, wherein the processing unit is configured for determining whether one or several of the predefined fields are missing a specific information, and for each of said predefined fields which are missing some specific information, then the processing unit is configured for automatically conducting a chatbot and/or acquiring a video.

Preferentially, the chatbot is configured for interacting by voice with an operator. For instance, when the system according to the invention determines that a specific information, i.e. some knowledge asset requiring some verbal explanation, is missing and/or has not been explicitly defined yet, then the system is configured for automatically asking a predefined corresponding specific question to the operator and for automatically recording his response either in natural language and/or by using the collaborative graphical user interface.

The chatbot is therefore configured for collecting audio and/or textual information from the operator, and the system then automatically stores the collected audio and/or textual information as specific information for the concerned field. Typically, the chatbot will focus only on questions requiring some verbal explanation (such as an experiment observation, or a reason behind a key decision). Preferentially, the information acquisition system according to the invention comprises as input device a headphone/microphone combo for recording each answer to chatbot questions in natural language. Preferentially, each answer is recorded by the system in 2 formats: as an audio file and as a textual information after having been parsed by a voice recognition algorithm. Optionally, the system according to the invention is configured for enabling an operator amending a displayed textual information directly in the collaborative graphical user interface.

In the following, some examples of questions that can be asked by the chatbot according to the invention are presented:
- In the case of a process step called "formulation", wherein the system detects that there are no recorded operating instructions, then the chatbot is configured for providing the following message: "Do you want to describe some working instructions for process step called 'formulation'?". If the operator answers "yes" within an acceptable response time predefined within the system, then the latter is configured for automatically recording an explanation of the operator and storing said explanation as a textual information as an EWI of the instruction field;
- If for a given CPP, there is no "Impact on CQA" recorded, the chatbot will ask: "Do you know which are the CQAs influenced by the 'reactor speed' CPP?"
- If for a given experiment, there is no input reason, the chatbot will ask: "What was the purpose of the experiment '248' ?"
- If for a given experiment, there is no input result, the chatbot will ask: "What was the observation you made from experiment '248'?"
- Etc.

Consequently, the system according to the invention is capable of translating tacit knowledge into textual information. Advantageously, the resulting textual information might then be used for some advanced searching actions on previous input information, from past experiments or product developments, and/or for automatically translating the initial language of the voice recording into another language, and/or for making correlations between past experiments observations.

Preferentially, the chatbot is automatically launched by the system according to the invention as soon as the system identifies an operator involved in the production process of the new product, e.g. from a logging of the operator into the system according to the invention of said operator or into a network connected to the system according to the invention. Preferentially, the system might be configured for sending an email to said operator, wherein said email comprises a question of the chatbot in the case said question has not yet been responded by the operator if a predefined time period has lapsed since the last time said question was asked or since the last time the operator was identified. In this case, the system is further configured for collecting an email response from the operator with respect to the sent question and to record the response as a textual information into a corresponding field of the production process model. In particular, if the operator does not answer to the email after a predefined time period, then the system is configured for sending the previously sent email to a peer of the operator who is also part of the same tech transfer project. For this purpose, the system may comprise in its database a list of persons involved for each tech transfer project.

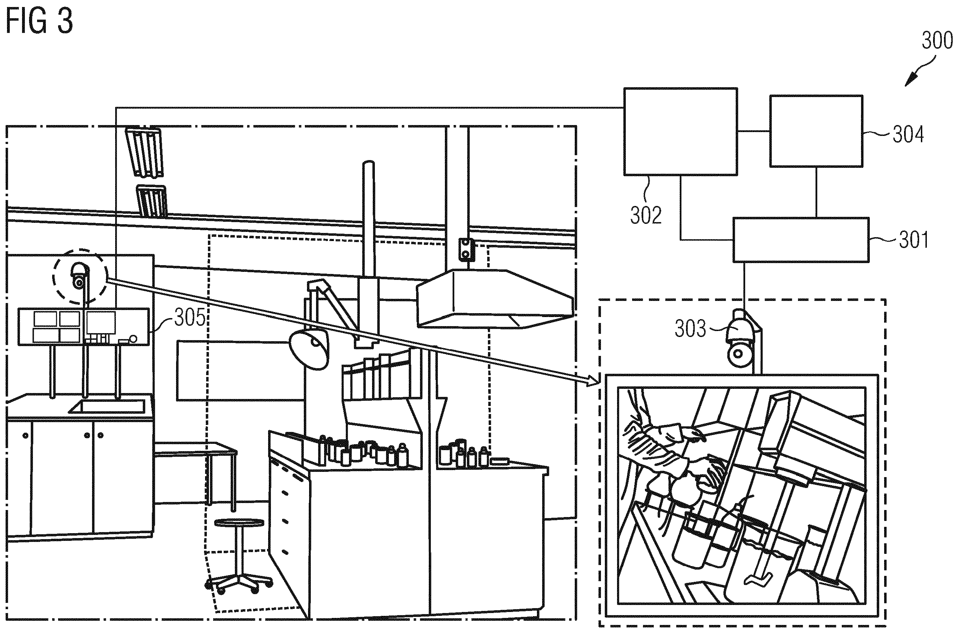

Figure 3 shows a preferred embodiment of the system 300 according to the invention. It comprises an information acquisition system 301 connected to a processing unit 302 comprising one or several processor, and comprising at least one input device configured for acquiring information regarding the production process. Such input device is for instance a video camera system 303. It might be also a microphone, a keyboard, a touchscreen, or any device which enables to acquire information by observing a scene representing a step of the production process and/or by interacting with an operator. The system 300 may further comprise a memory or database 304 for storing any record, as well as the predefined structured models. Said database 304 is for instance connected to the processing unit 302 and/or the information acquisition system 301. Optionally, the system 300 may also comprise one or several displays 305 and/or a collaborative graphical user interface. The information acquisition system 301 is typically configured for being installed within a laboratory in order to acquire production process knowledge from development steps of the production process for a new product.

Instead of the chatbot or together or in cooperation with the chatbot, the processing unit 302 is configured for controlling the camera system 303 for acquiring missing information with respect to one or several fields of the production process model. For instance, it is configured for detecting a handling or use of a specific machine or equipment within the laboratory, said detection triggering the start of a video recording process. Said video recording process may automatically start a recording of a process step of the production process by means of the camera as soon as an interaction of an operator with said machine or equipment is detected or identified, and/or may use the chatbot for asking the operator whether the handling has to be recorded and only starts the recording in case of an identification of a positive answer from the operator. The video recording enables to collect additional know-how with respect to machine/equipment handling for a considered step of the production process.

Preferentially, the processing unit is configured for identifying within images of a laboratory, each equipment/machine that might be potentially used with respect to a production process. From this knowledge of the position and/or from a connection to some equipment/machine, the system according to the invention is able to identify whether an operator is going to interact or is interacting with said equipment machine. Said identification might be based for instance on a machine learning algorithm configured for detecting an interaction of an operator with a machine/equipment from a flow of images acquired by the video system. For instance, if an interaction is detected in images acquired by the camera system 303, then the processing unit 302 may automatically start a video recording of the handling of the equipment/machine until an end of the interaction with the machine/equipment is detected, at which time the processing system 302 automatically stops the recording and stores a corresponding video file in the memory 304 for a specific field of the production process model. Said field is for instance a field comprising an indication that said machine/equipment has to be used for the corresponding step. For instance, the processing unit is configured for identifying each field of the production process model comprising a handling of said machine/equipment, and asking via the chatbot which of said fields is the correct one with respect to the concerned step. Preferentially, the information acquisition system may also comprise a motion sensor that may cooperate with the camera system 303 in order to trigger the start of the recording. The motion sensor is typically configured for detecting motion with respect to a single machine/equipment within the laboratory. In that case, the processing unit 302 will start the video recording process each time the motion sensor made a detection for said single machine/equipment, by activating a camera of the camera system which points to said single machine/equipment, or which comprises said single machine/equipment in its field of view. Preferentially, at the end of the video recording session, a message is sent to the laboratory operator, e.g. via the chatbot, or via a loudspeaker of the information acquisition system, asking said operator whether he wants to keep or erase the video record. Preferably, if the operator selects to keep the video record, then the chatbot might be configured for asking the operator to input some contextual information on that record. A microphone or any other input device of the information acquisition system 301 might be used for recording the contextual information provided by the operator. Preferentially, the contextual information provided by the operator is automatically recorded in two formats: as an audio file and as a textual information after having been parsed by a voice recognition algorithm. Optionally, the system is configured for enabling the operator amending a displayed textual information directly in the collaborative graphical user interface.

The contextual information could typically contain a process step name, reference, or identifier, as well as a description of the step or some observations made by the lab operator, etc. The video record, along with the recorded contextual information might be then automatically and jointly stored in the memory 304 (at the right location with respect to the field, thanks to the added context), allowing the system to link it to the correct production process field. Eventually, information recorded with respect to the handling of a machine/equipment might be automatically integrated into some electronic work instruction for the considered production process step, and might then be automatically displayed by the system to a shop floor operator asked to do the same kinds of equipment/machine handling on a production line.

The processing unit 302 is thus configured for checking whether each field of the production process model has been reviewed. By reviewing it has to be understood that for each field, the system will automatically record some information or withdraw said field from the production process step due to an acquisition of information by the system and from the operator that the field is not relevant or required with respect to the production process step.

Once all fields have been reviewed by the processing unit 302, the system automatically outputs, at step 103, a completed production process model that can be used by a receiving site for the industrial production of a product according to the production process steps developed by the issuing site.

Compared to existing solutions, the present invention presents the following advantages:
- it accelerates the pharmaceutical time-to-market, automatizing a human knowledge transfer process in a very usable and flexible way, making this knowledge reusable for future development projects within R&D and during tech transfers towards production, reducing development costs, and improving tech transfer First-Time Right Ratio (i.e. the ratio of getting things right the first time, to better manage risk assessment, which means doing more defect prevention than defect detection and reworking).
- it is able to extract tacit knowledge from an interaction with an operator or by recording actions/experiments realized in a lab, so that a corresponding knowledge is automatically made available within a predefined structured production process model.

Other advantages of the present invention are also:
- a deeper understanding of the product and process;
- a reduction in time and effort for a tech transfer project;
- a paper documentation reduction;
- a First Time Right improvement;
- a deeper collaboration between R&D and Production stake-holders;
- a continuous improvement with the Closed-Loop Manufacturing approach;
- a correlation between laboratory batches / experiments and production batches;
- a reduction in time and effort of future product development projects.

## Claims

1. Method for automatically capturing technology transfer knowledge for the production of a new product, the method comprising:
a) acquiring (101) a production process model;
b) automatically capturing (102) missing information within the production process model;
c) outputting (103) a completed production process model;
the method being **characterized in that**
- said production process model is a predefined structured model enabling to list successive production process steps required for producing the new product, wherein for each step of the production process, the predefined structured model comprises one or several predefined fields that are each configured for enabling an automatic recording of specific information with respect to the production process of the new product;
- a processing unit (302) is configured for determining whether one or several of said predefined fields are free of said specific information, and for each of said predefined fields which is free of said specific information, then the processing unit is configured for automatically launching a video recording process for each field which is identified as requiring an equipment/machine handling for a process step of the production process, until all fields of the predefined structured model have been reviewed by the processing unit, wherein a detection of said equipment/machine handling is configured for triggering a start of the video recording process;
- the completed production process model is outputted once all fields have been reviewed by the processing unit.

2. The method according to claim 1, wherein for each of said predefined fields which is free of said specific information, then the processing unit is configured for
automatically triggering and conducting a chatbot until all fields of the predefined structured model have been reviewed by the processing unit.

3. Method according to claim 2, wherein the processing unit (302) is configured for collecting audio and/or textual information by means of the chatbot and with respect to a process step for producing the new product, and storing the collected audio and/or textual information as specific information for the concerned field.

4. Method according to claim 1 to 3, wherein said video recording process comprises automatically detecting an interaction with said equipment/machine, starting a video recording of the handling of the equipment/machine, automatically stopping the recording, and storing the video recording as specific information for the concerned field.

5. System for automatically capturing technology transfer knowledge for the production of a new product, the system comprising:
- an information acquisition system (301), connected to a processing unit (302), comprising at least an input device for automatically collecting information concerning a production step, and configured for acquiring a production process model;
- a memory (304), connected to the information acquisition system (301), for storing the production process model;
- the processing unit (302);
the system being **characterized in that**
- the production process model is a predefined structured model enabling to list successive process steps required for producing the new product, wherein for each step, the predefined structured model comprises one or several predefined fields that are each configured for enabling a recording of specific information with respect to the production process of the new product;
- the memory is configured for storing said specific information;
- the processing unit (302) is configured for automatically capturing, by controlling the information acquisition system (301), missing information within the production process model until all fields of the predefined structured model have been reviewed by the processing unit, wherein the processing unit (302) is configured for automatically launching, by means of the information acquisition system (301), a video recording process for each of said predefined fields which is free of said specific information and identified as requiring an equipment/machine handling for a process step of the production process, wherein a detection of said equipment/machine handling is configured for triggering a start of the video recording process, the processing unit (302) being further configured for automatically storing a completed production process model in the memory once all fields have been reviewed by the processing unit (302).

6. System according to claim 5, wherein for each of said predefined fields which is free of said specific information, the processing unit (302) is configured for
i) automatically triggering and conducting, by means of the information acquisition system (301), a chatbot for collecting audio and/or textual information from a person involved in a development of the new product, and storing the collected audio and/or textual information as specific information for the concerned field.

7. System according to claim 5 or 6, wherein the video recording process comprises automatically detecting an interaction with said equipment/machine, starting a video recording of the handling of the equipment/machine in case of a detected interaction, automatically stopping the recording in case of an end of the detected interaction, and storing the video recording in the memory (304) as specific information for the concerned field.

8. System according to one of the claims 5 to 7, wherein the information acquisition system (301) comprises a camera system (303) .

9. System according to one of the claims 5 to 8, wherein the information acquisition system (301) comprises a motion sensor.

## Patentansprüche

1. Verfahren zum automatischen Erfassen von Technologietransferwissen zur Fertigung eines neuen Produkts,
wobei das Verfahren Folgendes umfasst:
a) Abrufen (101) eines Fertigungsprozessmodells,
b) automatisches Erfassen (102) von fehlenden Informationen in dem Fertigungsprozessmodell,
c) Ausgeben (103) eines fertiggestellten Fertigungsprozessmodells,
wobei das Verfahren **dadurch gekennzeichnet ist, dass**
- es sich bei dem Fertigungsprozessmodell um ein vordefiniertes strukturiertes Modell handelt, das ein Auflisten von aufeinanderfolgenden Fertigungsprozessschritten ermöglicht, die zum Fertigen des neuen Produkts erforderlich sind, wobei das vordefinierte strukturierte Modell bei jedem Schritt des Fertigungsprozesses ein oder mehrere vordefinierte Felder umfasst, die jeweils so konfiguriert sind, dass sie ein automatisches Aufzeichnen bestimmter Informationen in Bezug auf den Fertigungsprozess für das neue Produkt ermöglichen,
- eine Verarbeitungseinheit (302) so konfiguriert ist, dass sie bestimmt, ob ein oder mehrere der vordefinierten Felder keine der bestimmten Informationen enthalten, und die Verarbeitungseinheit dann so konfiguriert ist, dass sie für jedes der vordefinierten Felder, das keine der bestimmten Informationen enthält, automatisch einen Videoaufzeichnungsprozess für jedes Feld startet, von dem ermittelt wird, dass es eine Ausrüstungs-/Maschinenbedienung für einen Prozessschritt in dem Fertigungsprozess erfordert, bis alle Felder des vordefinierten strukturierten Modells von der Verarbeitungseinheit überprüft worden sind, wobei eine Erfassung der Ausrüstungs-/Maschinenbedienung so konfiguriert ist, dass sie einen Start des Videoaufzeichnungsprozesses auslöst,
- das fertiggestellte Fertigungsprozessmodell ausgegeben wird, wenn alle Felder von der Verarbeitungseinheit überprüft worden sind.

2. Verfahren nach Anspruch 1, wobei die Verarbeitungseinheit so konfiguriert ist, dass sie für jedes der vordefinierten Felder, das keine der bestimmten Informationen enthält, automatisch einen Chatbot auslöst und ausführt, bis alle Felder des vordefinierten strukturierten Modells von der Verarbeitungseinheit überprüft worden sind.

3. Verfahren nach Anspruch 2, wobei die Verarbeitungseinheit (302) so konfiguriert ist, dass sie mithilfe des Chatbots Ton- und/oder Textinformationen in Bezug auf einen Prozessschritt zum Fertigen des neuen Produkts sammelt und die gesammelten Ton- und/oder Textinformationen als bestimmte Informationen für das betreffende Feld speichert.

4. Verfahren nach Anspruch 1 bis 3, wobei der Videoaufzeichnungsprozess ein automatisches Erfassen einer Interaktion mit der Ausrüstung/Maschine, ein Starten einer Videoaufzeichnung der Bedienung der Ausrüstung/Maschine, ein automatisches Stoppen der Aufzeichnung und ein Speichern der Videoaufzeichnung als bestimmte Informationen für das betreffende Feld umfasst.

5. System zum automatischen Erfassen von Technologietransferwissen zur Fertigung eines neuen Produkts,
wobei das System Folgendes umfasst:
- ein Informationsabrufsystem (301), das mit einer Verarbeitungseinheit (302) verbunden ist und mindestens eine Eingabevorrichtung zum automatischen Sammeln von Informationen zu einem Fertigungsschritt umfasst und so konfiguriert ist,
dass es ein Fertigungsprozessmodul abruft,
- einen Arbeitsspeicher (304) zum Speichern des Fertigungsprozessmoduls, der mit dem Informationsabrufsystem (301) verbunden ist,
- die Verarbeitungseinheit (302),
wobei das System **dadurch gekennzeichnet ist, dass**
- es sich bei dem Fertigungsprozessmodell um ein vordefiniertes strukturiertes Modell handelt, das ein Auflisten von aufeinanderfolgenden Prozessschritten ermöglicht, die zum Fertigen des neuen Produkts erforderlich sind, wobei das vordefinierte strukturierte Modell bei jedem Schritt ein oder mehrere vordefinierte Felder umfasst, die jeweils so konfiguriert sind, dass sie ein Aufzeichnen bestimmter Informationen in Bezug auf den Fertigungsprozess für das neue Produkt ermöglichen,
- der Arbeitsspeicher so konfiguriert ist, dass er die bestimmten Informationen speichert,
- die Verarbeitungseinheit (302) so konfiguriert ist, dass sie durch Steuern des Informationsabrufsystems (301) automatisch fehlende Informationen in dem Fertigungsprozessmodell erfasst, bis alle Felder des vordefinierten strukturierten Modells von der Verarbeitungseinheit überprüft worden sind, wobei die Verarbeitungseinheit (302) so konfiguriert ist, dass sie mithilfe des Informationsabrufsystems (301) automatisch einen Videoaufzeichnungsprozess für jedes der vordefinierten Felder startet, das keine bestimmten Informationen enthält und von dem ermittelt wird, dass es eine Ausrüstungs-/Maschinenbedienung für einen Prozessschritt in dem Fertigungsprozess erfordert, wobei ein Erfassen der Ausrüstungs-/Maschinenbedienung so konfiguriert ist, dass es einen Start des Videoaufzeichnungsprozesses auslöst, wobei die Verarbeitungseinheit (302) ferner so konfiguriert ist, dass sie automatisch ein fertiggestelltes Fertigungsprozessmodell im Arbeitsspeicher speichert, wenn alle Felder von der Verarbeitungseinheit (302) überprüft worden sind.

6. System nach Anspruch 5, wobei die Verarbeitungseinheit (302) so konfiguriert ist, dass sie für jedes der vordefinierten Felder, das keine der bestimmten Informationen enthält,
i) mithilfe des Informationsabrufsystems (301) automatisch einen Chatbot zum Sammeln von Ton- und/oder Textinformationen von einer Person auslöst und ausführt, die an einer Entwicklung des neuen Produkts beteiligt ist, und die gesammelten Ton- und/oder Textinformationen als bestimmte Informationen für das betreffende Feld speichert.

7. System nach Anspruch 5 oder 6, wobei der Videoaufzeichnungsprozess ein automatisches Erfassen einer Interaktion mit der Ausrüstung/Maschine, ein Starten einer Videoaufzeichnung der Bedienung der Ausrüstung/Maschine bei einer erfassten Interaktion, ein automatisches Stoppen der Aufzeichnung bei einem Ende der erfassten Interaktion und ein Speichern der Videoaufzeichnung als bestimmte Informationen für das betreffende Feld im Arbeitsspeicher (304) umfasst.

8. System nach einem der Ansprüche 5 bis 7, wobei das Informationsabrufsystem (301) ein Kamerasystem (303) umfasst.

9. System nach einem der Ansprüche 5 bis 8, wobei das Informationsabrufsystem (301) einen Bewegungssensor umfasst.

## Revendications

1. Procédé de capture automatique de connaissances de transfert de technologie pour la production d'un nouveau produit, le procédé comprenant :
a) l'acquisition (101) d'un modèle de processus de production ;
b) la capture automatique (102) d'informations manquantes au sein du modèle de processus de production ;
c) la sortie (103) d'un modèle de processus de production achevé ;
le procédé étant **caractérisé en ce que**
- ledit modèle de processus de production est un modèle structuré prédéfini permettant de lister des étapes de processus de production successives nécessaires pour produire le nouveau produit, dans lequel pour chaque étape du processus de production, le modèle structuré prédéfini comprend un ou plusieurs champs prédéfinis qui sont chacun configurés pour permettre un enregistrement automatique d'informations spécifiques par rapport au processus de production du nouveau produit ;
- une unité de traitement (302) est configurée pour déterminer si l'un ou plusieurs desdits champs prédéfinis sont exempts desdites informations spécifiques, et pour chacun desdits champs prédéfinis qui est exempt desdites informations spécifiques, alors l'unité de traitement est configurée pour lancer automatiquement un processus d'enregistrement vidéo pour chaque champ qui est identifié comme nécessitant une manipulation d'équipement/de machine pour une étape de processus du processus de production, jusqu'à ce que tous les champs du modèle structuré prédéfini aient été examinés par l'unité de traitement, dans lequel une détection de ladite manipulation d'équipement/de machine est configurée pour déclencher un démarrage du processus d'enregistrement vidéo ;
- le modèle de processus de production achevé est délivré en sortie une fois que tous les champs ont été examinés par l'unité de traitement.

2. Procédé selon la revendication 1, dans lequel pour chacun desdits champs prédéfinis qui est exempt desdites informations spécifiques, alors l'unité de traitement est configurée pour
déclencher et exécuter automatiquement un robot conversationnel jusqu'à ce que tous les champs du modèle structuré prédéfini aient été examinés par l'unité de traitement.

3. Procédé selon la revendication 2, dans lequel l'unité de traitement (302) est configurée pour collecter des informations audio et/ou textuelles au moyen du robot conversationnel et par rapport à une étape de processus pour produire le nouveau produit, et stocker les informations audio et/ou textuelles collectées en tant qu'informations spécifiques pour le domaine concerné.

4. Procédé selon la revendication 1 à 3, dans lequel ledit processus d'enregistrement vidéo comprend la détection automatique d'une interaction avec ledit équipement/ladite machine, le démarrage d'un enregistrement vidéo de la manipulation de l'équipement/de la machine, l'arrêt automatique de l'enregistrement, et le stockage de l'enregistrement vidéo en tant qu'informations spécifiques pour le domaine concerné.

5. Système de capture automatique de connaissances de transfert de technologie pour la production d'un nouveau produit, le système comprenant :
- un système d'acquisition d'informations (301), connecté à une unité de traitement (302), comprenant au moins un dispositif d'entrée pour collecter automatiquement des informations concernant une étape de production, et configuré pour acquérir un modèle de processus de production ;
- une mémoire (304), connectée au système d'acquisition d'informations (301), pour stocker le modèle de processus de production ;
- l'unité de traitement (302) ;
le système étant **caractérisé en ce que**
- le modèle de processus de production est un modèle structuré prédéfini permettant de lister des étapes de processus successives nécessaires pour produire le nouveau produit, dans lequel pour chaque étape, le modèle structuré prédéfini comprend un ou plusieurs champs prédéfinis qui sont chacun configurés pour permettre un enregistrement d'informations spécifiques par rapport au processus de production du nouveau produit ;
- la mémoire est configurée pour stocker lesdites informations spécifiques ;
- l'unité de traitement (302) est configurée pour capturer automatiquement, par la commande du système d'acquisition d'informations (301), des informations manquantes au sein du modèle de processus de production jusqu'à ce que tous les champs du modèle structuré prédéfini aient été examinés par l'unité de traitement, dans lequel l'unité de traitement (302) est configurée pour lancer automatiquement, au moyen du système d'acquisition d'informations (301), un processus d'enregistrement vidéo pour chacun desdits champs prédéfinis qui est exempt desdites informations spécifiques et identifié comme nécessitant une manipulation d'équipement/de machine pour une étape de processus du processus de production, dans lequel une détection de ladite manipulation d'équipement/de machine est configurée pour déclencher un démarrage du processus d'enregistrement vidéo, l'unité de traitement (302) étant en outre configurée pour stocker automatiquement un modèle de processus de production achevé dans la mémoire une fois que tous les champs ont été examinés par l'unité de traitement (302).

6. Système selon la revendication 5, dans lequel pour chacun desdits champs prédéfinis qui est exempt desdites informations spécifiques, l'unité de traitement (302) est configurée pour i) déclencher et exécuter automatiquement, au moyen du système d'acquisition d'informations (301), un robot conversationnel pour collecter des informations audio et/ou textuelles auprès d'une personne impliquée dans un développement du nouveau produit, et stocker les informations audio et/ou textuelles collectées en tant qu'informations spécifiques pour le domaine concerné.

7. Système selon la revendication 5 ou 6, dans lequel le processus d'enregistrement vidéo comprend la détection automatique d'une interaction avec ledit équipement/ladite machine, le démarrage d'un enregistrement vidéo de la manipulation de l'équipement/de la machine dans le cas d'une interaction détectée, l'arrêt automatique de l'enregistrement dans le cas d'une fin de l'interaction détectée, et le stockage de l'enregistrement vidéo dans la mémoire (304) en tant qu'informations spécifiques pour le domaine concerné.

8. Système selon l'une des revendications 5 à 7, dans lequel le système d'acquisition d'informations (301) comprend un système d'appareil de prise de vues (303).

9. Système selon l'une des revendications 5 à 8, dans lequel le système d'acquisition d'informations (301) comprend un capteur de mouvement.
